# EUROPÄISCHE PATENTANMELDUNG

(11) **EP 1 439 548 A1**
(43) Veröffentlichungstag der Anmeldung: **21.07.2004**
(21) Anmeldenummer: 03405020.3
(22) Anmeldetag: 20.01.2003
(51) Int. Cl.: H01C 7/12, G01R 15/14

(54) **Einbaumodul für Hochspannungsanlage**

(71) Anmelder: ABB RESEARCH LTD., 8050 Zürich (CH)
(72) Erfinder: Greuter, Felix, 5406 Rütihof (CH); Brändle, Hubert, 8102 Oberengstringen (CH); Bohnert, Klaus, 5452 Oberrohrdorf (CH)
(74) Vertreter: ABB Patent Attorneys

(57) **Zusammenfassung**

Das Einbaumodul weist einen längs einer Achse erstreckten Isolator (1) auf mit einer eine Beschirmung aufweisenden Mantelfläche und mit zwei an Stirnseiten des Isolators angebrachten Stromanschlüssen (2, 3). Ferner enthält das Einbaumodul ein Aktivteil eines Überspannungsableiters mit einer parallel zur Achse ausgerichteten Säule (4) aus nichtlinearen Widerstandselementen (5) sowie einen im Isolatorinneren angeordneten Spannungssensor (7) zur Detektion einer an das Modul anlegbaren Hochspannung.

Diese Modul soll mit geringem Aufwand und unter Beibehalt einer kompakten Bauweise eine Vielzahl von Funktionen ausführen. Dies wird dadurch erreicht, dass das Aktivteil und der Spannungssensor (7) in einem axial erstreckten und von den beiden Stromanschlüssen (2, 3) axial begrenzten Hohlraum des Isolators (1) angeordnet sind, oder dass der Isolator gebildet ist von elektrisch isolierenden, die Säule mechanisch stabilisierenden Spannelementen und einer elastomeren Umhüllung, in welche zumindest das Aktivteil und die Spannelemente eingebettet sind, und dass der Spannungssensor (7) Mittel (9, 20) zur Detektion einer über einen Abschnitt der Säule (4) abfallenden Teilspannung aufweist.

## Beschreibung

### TECHNISCHES GEBIET

Bei der Erfindung wird ausgegangen von einem Einbaumodul für eine Hochspannungsanlage nach dem Oberbegriff von Patentanspruch 1. Dieses Einbaumodul enthält einen längs einer Achse erstreckten Isolator, ein Aktivteil eines Überspannungsableiters sowie einen im Isolatorinneren angeordneten Spannungssensor zur Detektion einer an das Modul anlegbaren Spannung. Der Isolator weist eine als Beschirmung ausgeführte Mantelfläche und zwei an Stirnseiten des Isolators angebrachte und mit dem Aktivteil elektrisch leitend verbundene Stromanschlüsse auf. Das Aktivteil enthält mindestens eine parallel zur Achse ausgerichteten Säule aus nichtlinearen Widerstandselementen. Ein solches Modul kann neben Spannungsbegrenzung und Spannungserfassung gegebenenfalls noch weiteren Funktionen ausführen, wie etwa das Führen einer Antriebsstange für einen Hochspannungsschalter. Da diese unterschiedlichen Funktionen von einem einzigen Modul ausgeführt werden, kann ein solches Modul kompakt ausgebildet sein und kann in kostengünstiger Weise gefertigt und in einfacher Weise montiert werden.

### STAND DER TECHNIK

Mit dem Oberbegriff nimmt die Erfindung auf einen Stand der Technik von elektrischen Apparaten Bezug, wie er in DE 100 20 129 C1 beschrieben ist. Eine in dieser Patentveröffentlichung dargestellte Baugruppe besteht aus einem als Verbundkörper ausgeführten Isolator und einem baulich mit dem Isolator vereinigten Überspannungsableiter. Ein als Säule von Widerstandselementen ausgebildetes Aktivteil des Überspannungsableiters ist in eine elastomere Beschirmung des Isolators eingebettet, welche Beschirmung auf der Mantelfläche eines glasfaserverstärkten Kunststoffrohr angebracht ist. Der Innenraum des Kunststoffrohrs kann ein elektrisches Bauteil, etwa eine Durchführung mit oder ohne Kondensatorsteuerung, ein mit einer Feldsteuerung oder einem Endverschluss versehenes Kabelende oder einen Spannungsteiler aufnehmen oder aber auch von einem mechanischen Bauteil, etwa einer Antriebsstange, durchsetzt sein. Zum Ausführen unterschiedlicher Funktionen, wie etwa Spannungsbegrenzung und Spannungserfassung oder aber Stromdurchführung und Spannungsbegrenzung, benötigt diese Baugruppe ein dielektrisch stark belastetes Kunststoffrohr, welches die Funktionen ausführende Komponenten voneinander trennt und der Einbaugruppe die erforderlich mechanische Stabilität gibt.

In DE 100 05 164 A1 ist ein als Durchführung ausgeführtes Einbaumodul angegeben, welches zur isolierten Einführung eines Stromleiters in eine Hochspannungseinrichtung, beispielsweise einen Transformator, dient. Bei diesem Modul werden eine am Leiter anliegende Hochspannung und ein vom Leiter geführter Strom durch faseroptisch ausgeführte Sensoren erfasst, welche in die Durchführung eingebaut sind.

Ein weiteres Einbaumodul für eine Hochspannungsanlage ist aus DE 196 47 736 C1 bekannt. Dieses Modul ist als Hochspannungs-Leistungsschalter ausgebildet und enthält einen hohlen Isolierstützer, an dessen einem Ende eine Unterbrechereinheit des Schalters angeordnet ist. Im Innenraum des Isolierstützers sind eine Antriebsstange zum Betrieb der Unterbrechereinheit und Ableitelemente eines Überspannungsableiters angeordnet.

EP 0 907 084 A2 zeigt ferner ein in eine Freiluft-Hochspannungsschaltanlage eingebautes Messgerät mit einem faseroptischer Spannungssensor und einer optoelektronischen Messapparatur. Der Spannungssensor enthält mehrere durch elektrisch leitenden Abstandselement voneinander beabstandete piezoelektrische Körper mit einer daran befestigten Sensorfaser sowie eine die Abstandselemente, die piezoelektrischen Körper und die Sensorfaser umgebende witterungsbeständige Isolierstoffumhüllung.

### DARSTELLUNG DER ERFINDUNG

Die Erfindung, wie sie in den Patentansprüchen definiert ist, löst die Aufgabe, ein Einbaumodul der eingangs genannten Art anzugeben, bei dem mit geringem Aufwand eine Vielzahl von Funktionen realisiert sind.

Beim Modul nach der Erfindung sind das Aktivteil des Überspannungsableiters und der Spannungssensor in einem axial erstreckten und von den beiden Stromanschlüssen axial begrenzten Hohlraum des Isolators angeordnet, oder ist der Isolator gebildet von elektrisch isolierenden, die Säule mechanisch stabilisierenden Spannelementen und einer elastomeren Umhüllung, in welche zumindest das Aktivteil und die Spannelemente eingebettet sind. Zudem weist der Spannungssensor Mittel zur Detektion einer über einen Abschnitt der Säule abfallenden Teilspannung auf. Hierdurch wird mit einfachen Mitteln ein Einbaumodul für eine Hochspannungsanlage erreicht, welches nicht nur die Funktionen von Spannungsbegrenzung und Spannungsmessung in sich vereint, sondern welches darüber hinaus auch die Überwachung der Funktionsfähigkeit des Überspannungsableiters durch Messung der an diskreten Widerstandselementen der Ableitersäule anliegenden Teilspannungen ermöglicht. Aus dielektrischen Gründen und aus Gründen der Raumersparnis weist der Spannungssensor im allgemeinen einen auf eine Änderung des zu messenden elektrischen Feldes mit einer Änderung einer physikalischen Eigenschaft reagierenden Kristall auf. Als physikalische Eigenschaften werden hierbei vor allem die Änderung der Lichtbrechung (Pockelszelle) und der Abmessungen (piezoelektrischer Effekt) eines piezoelektrischen Kristalls ausgenutzt.

Umfasst das Modul einen Hochspannungsschalter, so kann Kraft von einem auf Erdpotential angeordneten Schalterantrieb auf eine auf dem Isolator angebrachte Kontaktanordnung des Schalters dadurch erreicht werden, dass der Isolator als Kraftübertragungselement ausgeführt und um die Achse des Moduls drehbar gelagert ist oder eine in Richtung der Säulenachse führbare Antriebsstange des Schalterantriebs aufnimmt. Bei Ausbildung des Isolators mit elastomerem Material kann die Antriebsstange in einem in das Elastomer eingegossenen Hohlraum oder Kunststoffrohr geführt sein.

Zusätzliche Funktionen können problemlos in das Modul integriert werden, indem im Hohlraum oder in der elastomeren Umhüllung zusätzlich eine Signalleitung, beispielsweise ein Lichtwellenleiter, eines gegebenenfalls ausserhalb des Isolators angeordneten weiteren Sensors geführt ist. Solch ein Sensor kann ein an einem stromführenden Leiter der Hochspannungssanlage ausserhalb des Isolators angebrachter Stromsensor oder irgendein anderer Zustandssensor sein, beispielsweise ein die Säule überwachender und daher im Isolatorinneren angebrachter Temperatursensor. Sind mehrere zusätzliche Funktionen auszuführen, so können anstelle eines zusätzlichen Sensors, beispielsweise eines Stromsensors, noch beliebige weitere Sensoren vorgesehen sein, beispielsweise einer für die Messung einer Temperatur, einer für die Messung einer Spannung, etwa der über der Ableitersäule abfallenden Gesamtspannung, und ein weiterer für die Messung eines Drucks.

In einer besonders raumsparenden Ausführungsform des erfindungsgemässen Moduls ist die Säule hohl ausgebildet, und sind im Säuleninneren der Spannungssensor, die Signalleitung für den weiteren Sensor und/oder die Antriebsstange der auf dem Isolator anbringbaren Kontaktanordnung des Hochspannungsschalters vorgesehen. Bei dieser Ausführungsform ist mit Vorteil zwischen zwei benachbarten Widerstandselementen der Säule ein mit dem Säuleninneren verbundenes, elektrisch leitendes Druckentlastungsorgan angeordnet. Bei Überlastung der Ableitersäule infolge Lichtbogenbildung im Säuleninneren auftretende Überdrücke können so rasch und sicher abgebaut werden.

Gegebenenfalls, beispielsweise, wenn höhere Ableitströme zu führen sind, weist das Aktivteil zwei oder mehr Säulen auf. Der Spannungssensor, die Signalleitung für den zusätzlichen Sensor und/oder die Antriebsstange des im Modul gegebenenfalls enthaltenen Hochspannungsschalters sind dann zu Zwecken einer guten Raumausnutzung zwischen diesen Säulen angeordnet. In einer weiteren kompakten Ausführungsform des Moduls ist in die Mantelfläche der Säule eine Materialausnehmung eingeformt. In dieser Ausnehmung sind der Spannungssensor und/oder die Signalleitung für den zusätzlichen Sensor angeordnet. Weitere Funktionen kann das Modul bei diesen beiden Ausführungsformen erfüllen, wenn es neben der Signalleitung für den zusätzlichen Sensor eine oder mehrere weitere Signalleitungen für weitere Sensoren aufweist.

In einer vorteilhaften Ausführungsform der Erfindung weist das Modul einen der Detektion der Teilspannung und einer von der Teilspannung abweichenden Zustandsgrösse dienenden Spannungssensor auf. Dieser Spannungssensor benötigt nicht nur wenig Raum, er kann aus dielektrischen und mechanischen Gründen in vorteilhafter Weise sehr nahe an die Ableitersäule herangeführt werden. Er kann neben der Teilspannung in einem bestimmten Abschnitt der Ableitersäule zugleich auch eine davon abweichende Zustandsgrösse messen, beispielsweise die ans Modul angelegte Gesamtspannung, die Temperatur der Säule oder eines Säulenabschnitts, einen Druck oder einen Strom.

In einer besonders kompakt ausgeführten Ausführungsform der Erfindung weist der Spannungssensor ein die Teilspannung und die von der Teilspannung abweichende Zustandsgrösse detektierendes Sensorelement auf. Aus messtechnischen Gründen ist es günstig, dass das Sensorelement einen piezoelektrischen Körper enthält sowie zwei am piezoelektrischen Körper befestigte Sensorfasem, von denen eine erste der Detektion der Teilspannung und eine zweite der Detektion der von der Teilspannung abweichenden Zustandsgrösse dient. Zur Detektion einer ans Modul anlegbaren Gesamtspannung weist der Spannungssensor dann mit Vorteil eine Gruppe von piezoelektrischen Körpern auf mit einer allen piezoelektrischen Körpern gemeinsamen zweiten Sensorfaser. Sind an den piezoelektrischen Körpern weitere erste Sensorfasem befestigt, so können mit diesem Spannungssensor zugleich auch die in verschiedenen Abschnitten der Ableitersäule abfallenden Teilspannungen gemessen werden.

Eine fertigungstechnisch besonders einfache Ausführungsform des Moduls ist dadurch gekennzeichnet, dass der Spannungssensor mindestens zwei piezoelektrische Körper und mindestens zwei Sensorfasem aufweist, von welchen Sensorfasem je eine nur an jeweils einem der piezoelektrischen Körper befestigt ist. Mit diesem Modul können mit einer relativ geringen Anzahl an Sensorfasern in aufeinanderfolgenden Abschnitten der Ableitersäule die Teilspannungen gemessen und kann hieraus durch Addition die ans Modul legbare Gesamtspannung ermittelt werden.

Aufgrund der hohen Messgenauigkeit und -geschwindigkeit können die vorstehend beschriebenen Module sowohl Schutz- als auch Messfunktionen übernehmen. Mit geringerer Genauigkeit, aber geringerem Aufwand kann die Gesamtspannung unter Berücksichtigung von Eichfaktoren auch mit einer Gruppe von piezoelektrischen Körpern und zugeordneten Sensorfasern gemessen werden, welche nur an einigen ausgewählten Stellen der Ableitersäule die dort abfallenden Teilspannungen ermitteln. Da die Ableitersäule im allgemeinen aus nichtlinearen Widerstandselementen, etwa auf der Basis ZnO, mit stark feldsteuernder Wirkung aufgebaut ist, werden hierbei möglicherweise wirkende Einflüsse von Witterung und Verschmutzung reduziert.

Für eine gute Messgenauigkeit der Teilspannung sollte das der Detektion der Teilspannung dienende Sensorelement derart angeordnet sein, dass Säulenabschnitt und Sensorelement bei Anlegen der Teilspannung weitgehend dem gleichen elektrischen Feld ausgesetzt sind. Sind die beiden Kontaktflächen von Sensorelement und Säulenabschnitt elektrisch leitend miteinander verbunden, so kann die Teilspannung unabhängig von den Positionen des der Messung der Teilspannung dienenden Sensorelements und des Teilabschnitts der Ableitersäule mit hoher Genauigkeit bestimmt werden.

### BESCHREIBUNG DER ZEICHNUNGEN

Bevorzugte Ausführungsbeispiel der Erfindung und die damit erzielbaren weiteren Vorteile werden nachfolgend anhand von Zeichnungen näher erläutert. Hierbei zeigt:
- Fig.1: eine Aufsicht auf eine erste Ausführungsform eines teilweise geschnitten dargestellten Einbaumoduls nach der Erfindung,
- Fig.2: eine Aufsicht auf eine zweite Ausführungsform eines teilweise geschnitten dargestellten Einbaumoduls nach der Erfindung,
- Fig.3: eine Aufsicht auf einen längs III-III geführten Schnitt durch das Modul gemäss Fig.2,
- Fig.4: eine Aufsicht auf einen entsprechend Fig.3 geführten Schnitt durch eine dritte Ausführungsform des Einbaumoduls nach der Erfindung,
- Fig.5: eine Aufsicht auf einen entsprechend Fig.3 geführten Schnitt durch eine vierte Ausführungsform des Einbaumoduls nach der Erfindung,
- Fig.6: eine Aufsicht auf einen entsprechend Fig.3 geführten Schnitt durch eine fünfte Ausführungsform des Einbaumoduls nach der Erfindung,
- Fig.7: in Vergrösserung den unteren Teil des Einbaumoduls gemäss Fig.1, und
- Fig.8: eine Aufsicht auf einen Abschnitt einer hohl ausgebildeten Ableitersäule eines entsprechend Fig.2 ausgebildeten Einbaumoduls mit einem Druckentlastungsorgan.

### WEGE ZUR AUSFÜHRUNG DER ERFINDUNG

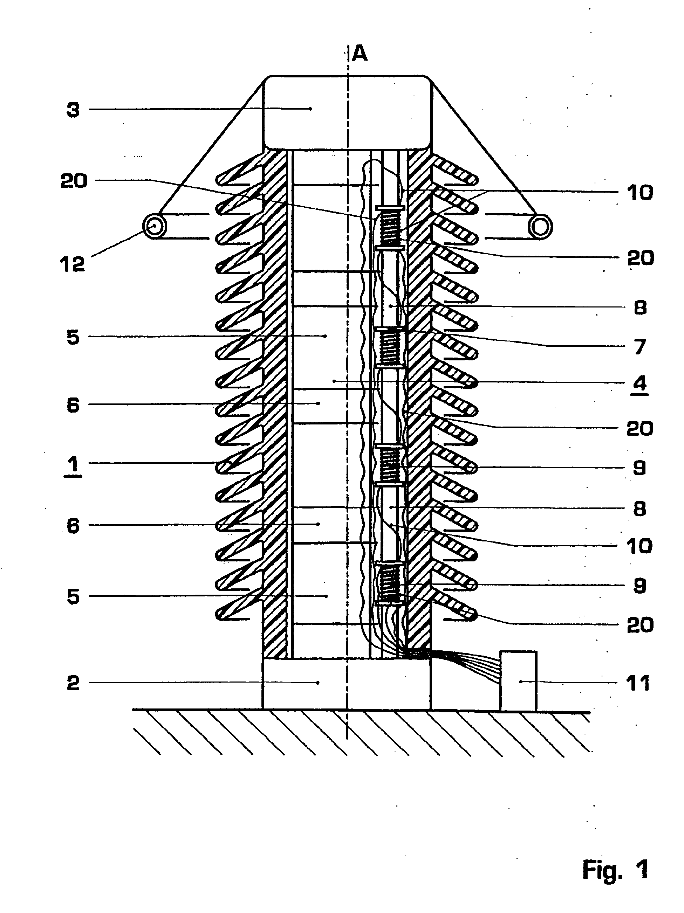

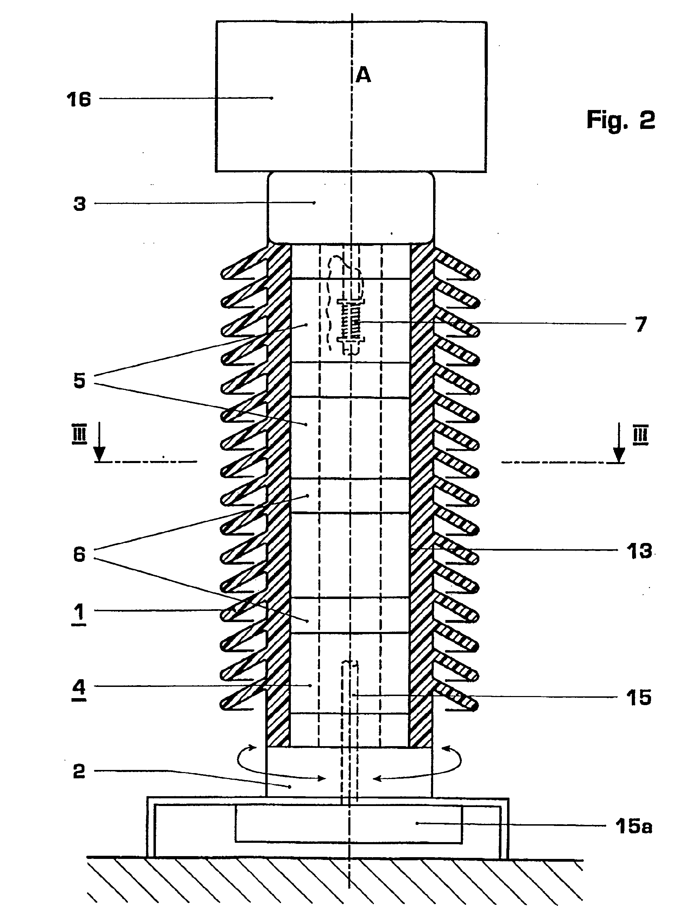

In allen Figuren bezeichnen gleiche Bezugszeichen auch gleichwirkende Teile. Die beiden in den Figuren 1 und 2 dargestellte Einbaumodule sind jeweils für den Einbau in eine mehrphasige Hochspannungs-Freiluftanlage, beispielsweise mit einer Spannung Phase zu Erde von 245 kV bestimmt. Sie weisen jeweils einen längs einer vertikalen Achse ausgerichteten Isolator 1 von zylindrischer Form auf. An einer unteren Stirnfläche des Isolators 1 ist ein auf Erdpotential befindlicher Stromanschluss 2 angebracht, an einer oberen Stirnfläche ein auf Hochspannungspotential führbarer Stromanschluss 3. Die zwischen den beiden Stimflächen angeordnete Mantelfläche des Isolators ist mit einer Wetterschutz-Beschirmung versehen.

Bei der Ausführungsform gemäss Fig.1 ist der Isolator 1 als Hohlzylinder ausgebildet und besteht aus einer Keramik, vorzugsweise Porzellan, oder aus einem faserverstärkten Verbundstoff auf der Basis eines Polymers, wie etwa Epoxid, und einer an den Verbundstoff angeformten Beschirmung auf der Basis eines Silikons. Der Hohlraum des Isolators 1 ist mit einem gas-, flüssigkeits- oder gelartigen Isoliermittel gefüllt und umschliesst ein als Säule 4 ausgeführtes Aktivteil eines Überspannungsableiters. Die Säule 4 besteht aus einem Stapel von nichtlinearen Widerstandselementen 5, etwa auf der Basis Zinkoxid, dotiert mit Metalloxiden. Zwischen aufeinanderfolgenden Widerstandselementen sind im Stapel Kontaktelemente 6 angeordnet. Die Säule 4 ist mit Vorspannung zwischen den beiden Stromanschlüssen 2 und 3 gehalten, wobei das oberste bzw. das unterste Widerstandselement der Säule 4 mit dem auf Hochspannungspotential führbaren Stromanschluss 3 bzw. dem auf Erdpotential befindlichen Stromanschluss 2 elektrisch leitend verbunden ist.

In Hohlraum ist ferner ein Spannungssensor 7 einer Spannungsmessvorrichtung angeordnet. Der Sensor ist wie das Aktivteil des Überspannungsableiters ebenfalls säulenförmig ausgebildet und ist mit geringem Abstand und parallel zur Säule 4 geführt. Der Spannungssensor enthält mehrere unabhängig voneinander wirkende, durch Abstandselemente 8 voneinander getrennte Sensorelemente mit jeweils einem zwischen zwei Kontaktflächen angeordneten piezoelektrischen Körper 9.

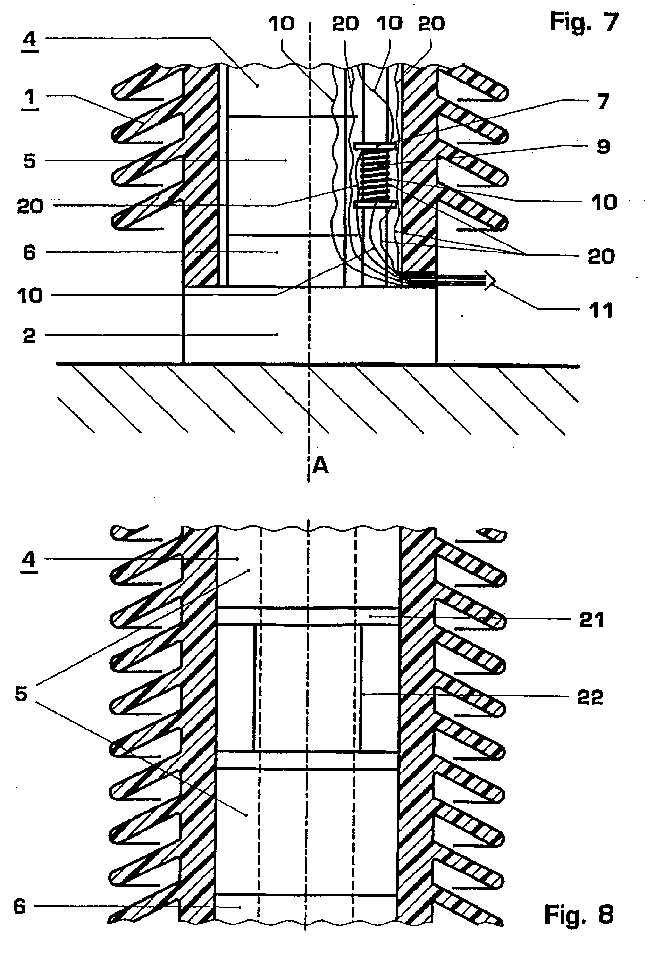

Auf allen piezoelektrischen Körpern 9 ist ein durch Wickeln aufgebrachter Abschnitt einer vorzugsweise als Glasfaser ausgebildeten Sensorfaser 10 befestigt. Die Sensorfaser 10 ist über den gesamten Spannungssensor 7 von unten nach oben und ausserhalb des Spannungssensors zurück nach unten geführt und dient der Übertragung eines in den piezoelektrischen Körpern 9 gebildeten Signals, welches der an das Einbaumodul angelegten Hochspannung proportional ist. Mit dem Bezugszeichen 20 sind zwei ebenfalls als Glasfaser ausgeführte Sensorfasem bezeichnet. Diese Fasern sind jeweils an einem von zwei der piezoelektrischen Körper 9 befestigt und dienen der Übertragung eines im zugeordneten piezoelektrischen Körpers 9 gebildeten Signals. Dieses Signal ist proportional einer Teilspannung der Hochspannung, welche Teilspannung an einem dem piezoelektrischen Körper benachbart angeordneten Teilabschnitt der Ableitersäule 4 anliegt. Die beiden Enden jeder der drei Fasern 10 und 20 sind am Fuss des Isolators 1 nach aussen in eine optoelektrische Auswerteeinheit 11 geführt. In dieser Auswerteeinheit 11 werden in bekannter Weise (EP 0 907 784 A2) aus den Fasern tretende und der anliegenden elektrischen Spannung entsprechende optische Signale ausgewertet. In Fig.7 sind Anordnung und Verlauf der Fasern 10 und 20 noch einmal vergrössert dargestellt. Aus dieser Darstellung ist ersichtlich, dass die Sensorfasem 20 im Unterschied zur Sensorfaser 10 nicht über die anderen piezoelektrischen Körper 9, sondern direkt mit der Auswerteeinheit 11 verbunden sind. Daher erfasst das die beiden Sensorfasem 10 und 20 enthaltende Sensorelement auch die Teilspannung der an den Stromanschlüssen 2, 3 anliegenden Gesamtspannung, nämlich die zwischen zwei Kontaktflächen eines Abschnitts der Säule 4 anliegende Teilspannung, hier die Spannung, die an dem in der Säule 4 zuunterst gelegenen Widerstandselements 5 anliegt.

Mit Hilfe eines auf dem gleichen elektrischen Potential wie der Stromanschluss 3 gehaltenen Steuerrings 12 wird die Verteilung des zwischen den beiden Anschlüssen 2 und 3 herrschenden elektrischen Feldes im Bereich der Ableitersäule 6, des Spannungssensors 7 und des Isolators 1 homogenisiert.

Die Abstandselemente sind mit Vorteil aus elektrisch nichtleitendem Material gefertigt. Es werden so Überhöhungen des elektrischen Feldes in der Nähe der piezoelektrischen Körper vermieden. Die piezoelektrischen Körper 9 sind im allgemeinen jeweils als relativ dünne Scheibe (Dicke beispielsweise z. B. 10 mm) ausgeführt. Die an der Säule anliegende Gesamtspannung wird so mit guter Näherung als Summe von lokalen Feldstärken approximiert.

Alternativ können aber auch vergleichsweise lange piezoelektrische Körper verwendet werden, die aus dielektrischen Gründen nicht zu nahe an die Widerstandselemente 5 herangeführt sind. Es können dann die Messgenauigkeit und Robustheit des Moduls verbessernde elektrisch leitende Verbindungen eingebaut werden. Diese Verbindungen verlaufen zwischen Kontakten, welche an den piezoelektrischen Körpern vorgesehen sind, und Kontakten, die an den Widerstandselementen angebracht sind. Grundsätzlich kann jeder piezoelektrischer Körper aber auch separat, also ohne Abstandselement, befestigt werden.

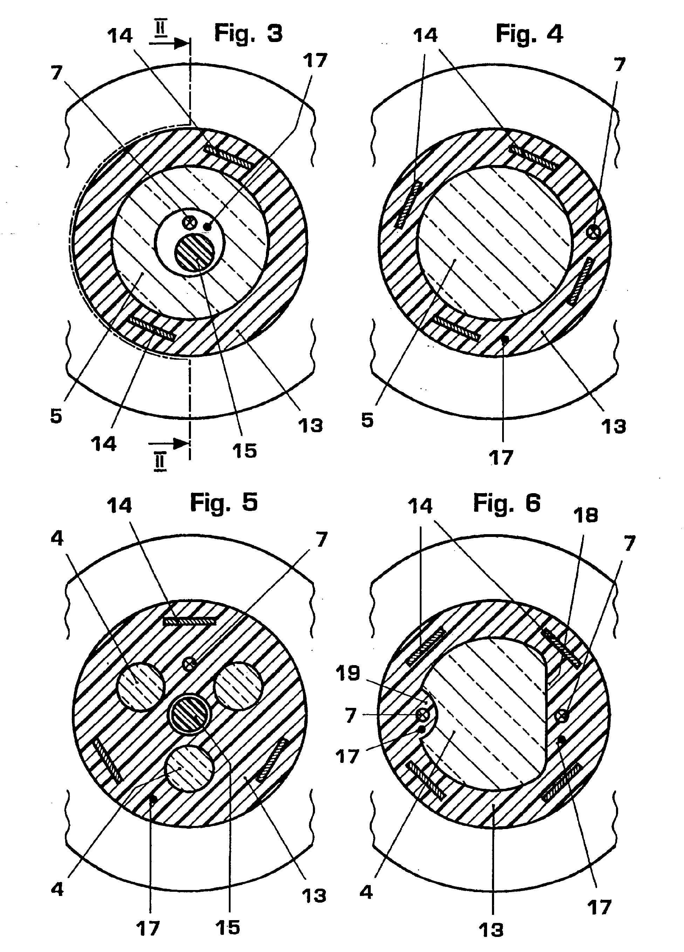

Bei der Ausführungsform nach Fig.2 ist der Isolator gebildet von elektrisch isolierenden, die Säule mechanisch stabilisierenden Spannelementen aus Isoliermaterial und einer elastomeren Umhüllung 13, in welche zumindest das als Widerstandssäule 4 ausgeführte Aktivteil und die aus den Figuren 3, 4 und 6 ersichtlichen Spannelemente 14 eingebettet sind. Die Spannelemente sind axial geführt und verspannen die beiden Stromanschlüsse 2, 3 gegeneinander. Die dazwischenliegenden nichtlinearen Widerstände 5 und Kontaktelemente 6 sind so mit einer vorbestimmten Vorspannkraft gehalten. Die Säule 4 ist hohl ausgebildet und weist im Säuleninneren den Spannungssensor 7 auf sowie eine von einem Antrieb 15 a in vertikaler Richtung verschiebbare Antriebsstange 15 für eine auf dem Isolator 1 angebrachten Kontaktanordnung 16 eines Hochspannungsschalters auf.

Alternativ kann Kraft von dem auf Erdpotential angeordneten Schalterantrieb 15 a auf die Kontaktanordnung des Schalters dadurch übertragen werden, dass der Isolator als Kraftübertragungselement ausgeführt und - wie durch Doppelpfeile angedeutet ist - um die Achse A des Moduls drehbar gelagert.

Aus Fig.3 ist ersichtlich, dass im Säuleninneren ferner eine beispielsweise als Lichtwellenleiter ausgeführter Signalleitung 17 eines gegebenenfalls ausserhalb des Isolators 1 angeordneten Zustandsensors, beispielsweise eines faseroptischen Stromsensors, eines Temperatursensors und/oder irgendeines anderen Sensors zur Überwachung oder Aktivierung des Moduls, geführt ist. Die Säule kann von halbschalenförmig ausgebildeten Widerstandselementen 3 gebildet sein. Tritt infolge eines oder mehrerer überlasteter Widerstandselemente 5 im Inneren der hohlen Säule ein Überdruck auf, so wird eine Druckentlastung des Hohlraums dadurch erreicht, dass sich die Halbschalen voneinander trennen und so den Hohlraum öffnen.

Aus Fig.4 ist ersichtlich, dass die Antriebsstange bei Ausführung des Einbaumoduls ohne Hochspannungsschalter entfallen kann, und dass der Lichtwellenleiter 17 des faseroptischen Stromsensors sowie der Spannungssensor 7 nicht notwendigerweise im Innenraum einer Säule 4 von hohl ausgebildeten Widerstandselementen 5 angeordnet sein müssen, sondern zwischen den Spannelementen 14 auch direkt in die Umhüllung 13 eingebettet sein können.

Wie Fig.5 zeigt, kann das Aktivteil des Überspannungsableiter statt einer Säule auch zwei, drei oder mehr parallel ausgerichtete und zueinander parallel geschaltete Säulen 4 enthalten, welche in die Umhüllung 13 eingebettet sind. Die Säulen weisen im allgemeinen kreisförmigen Querschnitt auf, können aber auch einen anderen Querschnitt aufweisen und beispielsweise elliptisch ausgeführt sein. In dem Zwischenraum zwischen den Säulen sind der Spannungssensor 7 und der beispielsweise als Lichtwellenleiter ausgeführte Signalleiter 17 des faseroptischen Stromsensors oder eines anderen Sensors in das Material der Umhüllung eingebettet. Der Signalleiter ist in einem nicht dargestellten dünnen Rohr angeordnet, in das er bei der Herstellung des Moduls leicht eingeschoben werden kann. Die Spannelemente 14 sind in dieser Figur nicht dargestellt. Ebenfalls in die elastomere Umhüllung 13 eingebettet ist ein nicht bezeichnetes Führungsrohr für die Antriebsstange 15.

In Fig.6 ist dargestellt, dass in die Mantelfläche der Säule 4 auch mindestens eine Materialausnehmung eingeformt sein kann. Diese Materialausnehmung kann von einer durch einen Sekantenschnitt der kreisrunden Säule 4 gebildeten, vorwiegend ebenen Fläche 18 begrenzt oder durch eine axial in der Mantelfläche der Säule geführte Nut 19 gebildet sein. In der Materialausnehmung sind der Spannungssensor 7 und der als Lichtwellenleiter ausgeführte Signalleiter 17 in das Material der Umhüllung 13 eingebettet.

Bei allen Ausführungsformen sind die Ableitersäule 4 und der Spannungssensor 7 relativ eng zueinander benachbart angeordnet. Dadurch ist ein kompakter Aufbau des Bauteils gewährleistet. Durch Ausbildung des Spannungssensors als faseroptischer Spannungssensor 7 ist zugleich sichergestellt, dass die Ableitersäule 4 und der Spannungssensor 7 über ihre ganze Länge praktisch der gleichen elektrischen Feldverteilung ausgesetzt sind.

Wie bei der Ausführungsform gemäss den Figuren 1 und 7 bereits beschrieben wurde, weist das Modul einen Spannungssensor 7 auf, welcher sowohl der Detektion der Teilspannung als auch der am Modul anliegenden Gesamtspannung dient. Der Spannungssensor kann anstelle der Gesamtspannung auch eine davon abweichende Zustandsgrösse messen, beispielsweise die Temperatur der Säule oder eines Säulenabschnitts, einen Druck oder einen Strom.

Für eine gute Messgenauigkeit ist es vorteilhaft, dass das der Detektion der Teilspannung dienende Sensorelement derart angeordnet ist, dass Säulenabschnitt und Sensorelement nach dem Einbau des Moduls in die Hochspannungsanlage weitgehend dem gleichen elektrischen Feld ausgesetzt sind. Dies kann zum einen durch die vorstehend beschriebene eng benachbarte Anordnung von Säulenabschnitt und Sensorelement erreicht werden, zum anderen aber auch dadurch, dass die beiden oberen Kontaktflächen von Sensorelement und Säulenabschnitt wie auch die beiden unteren Kontaktflächen von Sensorelement und Säulenabschnitt elektrisch leitend miteinander verbunden sind. In entsprechender Weise können so alle Widerstandselemente 5 der Säule 4 auf Teilspannung überwacht werden. Detektiert eines der Sensorelemente 9 eine zu geringe Teilspannung, so kann das defekte Widerstandselement 5 leicht erkannt und das Einbaumodul vor Eintritt eines Schadensfalls rechtzeitig revidiert werden.

Weist das Einbaumodul die in Fig.2 dargestellte hohle Ableitersäule 4 auf, so empfiehlt es sich, zusätzlich Mittel vorzusehen, um den im Säuleninneren angeordneten Spannungssensor 7 und damit das gesamte Modul vor Fehlverhalten, wie z. B. Überlastungen, zu schützen. Wie aus Fig.8 ersichtlich ist, können solche Mittel ein zwischen zwei benachbarten Widerstandselementen 5 der Säule 4 angeordnetes und mit dem Säuleninneren verbundenes, elektrisch leitendes Druckentlastungsorgan 21, vorzugsweise mit einer Membran 22, umfassen. Die Membran 22 bricht oberhalb eines Drucksollwertes von im Säuleninneren gespeicherten Druckgasen, die infolge unerwünschter Lichtbogenentladungen im Säuleninneren gebildet werden.

### BEZUGSZEICHENLISTE

- 1: Isolator
- 2, 3: Stromanschlüsse
- 4: Säule
- 5: Widerstandselemente
- 6: Kontaktelemente
- 7: Spannungssensor
- 8: Abstandselemente
- 9: piezoelektrische Körper
- 10: Sensorfaser
- 11: Auswerteeinheit
- 12: Steuerring
- 13: Umhüllung
- 14: Spannelemente
- 15: Antriebsstange
- 15a: Antrieb
- 16: Kontaktanordnung
- 17: Signalleitung, Lichtwellenleiter
- 18: Fläche
- 19: Nut
- 20: Sensorfaser
- 21: Druckentlastungsorgan
- 22: Membran

## Patentansprüche

1. Einbaumodul für eine Hochspannungsanlage mit
einem längs einer Achse (A) erstreckten Isolator (1), der eine als Beschirmung ausgebildete Mantelfläche und zwei an Stirnseiten des Isolators angebrachte Stromanschlüsse (2, 3) aufweist,
einem Aktivteil eines Überspannungsableiters mit mindestens einer parallel zur Achse ausgerichteten Säule (4) aus nichtlinearen Widerstandselementen (5), und
einem im Isolatorinneren angeordneten Spannungssensor (7) zur Detektion einer an das Modul anlegbaren Hochspannung,
**dadurch gekennzeichnet, dass** das Aktivteil und der Spannungssensor (7) in einem axial erstreckten und von den beiden Stromanschlüssen (2, 3) axial begrenzten Hohlraum des Isolators (1) angeordnet sind, oder dass der Isolator (1) gebildet ist von elektrisch isolierenden, die Säule (4) mechanisch stabilisierenden Spannelementen (14) und einer elastomeren Umhüllung (13), in welche zumindest das Aktivteil und die Spannelemente (14) eingebettet sind, und dass der Spannungssensor (7) Mittel zur Detektion einer über einen Abschnitt der Säule (4) abfallenden Teilspannung aufweist.

2. Modul nach Anspruch 1, **dadurch gekennzeichnet, dass** zur Betätigung einer auf dem Isolator (1) angebrachten Kontaktanordnung (16) eines Hochspannungsschalters der Isolator (1) als Kraftübertragungselement ausgeführt und um die Achse (A) drehbar gelagert ist oder eine in Richtung der Säulenachse (A) führbare Antriebsstange (15) eines Schalterantriebs (15a) aufnimmt.

3. Modul nach einem der Ansprüche 1 oder 2, **dadurch gekennzeichnet, dass** im Hohlraum oder in der elastomeren Umhüllung (13) eine Signalleitung (17) eines gegebenenfalls ausserhalb des Isolators (1) angeordneten weiteren Sensors geführt ist.

4. Modul nach einem der Ansprüche 1 bis 3, **dadurch gekennzeichnet, dass** die Säule (4) hohl ausgebildet ist, und dass im Säuleninneren der Spannungssensor (7), eine Signalleitung (17) für einen weiteren Sensor und/oder eine Antriebsstange (15) eines Schalterantriebs (15a) angeordnet sind.

5. Modul nach Anspruch 4, **dadurch gekennzeichnet, dass** zwischen zwei benachbarten Widerstandselementen (5) der Säule (4) ein mit dem Säuleninneren verbundenes, elektrisch leitendes Druckentlastungsorgan (21) angeordnet ist.

6. Modul nach einem der Ansprüche 1 bis 3, **dadurch gekennzeichnet, dass** das Aktivteil zwei oder mehr Säulen (4) aufweist, zwischen denen der Spannungssensor (7), eine Signalleitung (17) für einen weiteren Sensor und/oder eine Antriebsstange (15) einer auf dem Isolator (1) angebrachten Kontaktanordnung (16) eines Hochspannungsschalters angeordnet sind.

7. Modul nach einem der Ansprüche 1 bis 3, **dadurch gekennzeichnet, dass** in die Mantelfläche der Säule (4) eine Materialausnehmung (18, 19) eingeformt ist, in welcher der Spannungssensor (7) und/oder eine Signalleitung (17) für einen weiteren Sensor angeordnet sind.

8. Modul nach einem der Ansprüche 1 bis 7, **dadurch gekennzeichnet, dass** der Spannungssensor (7) der Detektion der Teilspannung und einer von der Teilspannung abweichenden Zustandsgrösse dient.

9. Modul nach Anspruch 8, **dadurch gekennzeichnet, dass** der Spannungssensor (7) ein die Teilspannung und die von der Teilspannung abweichende Zustandsgrösse detektierendes Sensorelement aufweist.

10. Modul nach Anspruch 9, **dadurch gekennzeichnet, dass** das Sensorelement einen piezoelektrischen Körper (9) und zwei am piezoelektrischen Körper befestigte Sensorfasem (10, 20) aufweist, von denen eine erste (20) der Detektion der Teilspannung und eine zweite (10) der Detektion der von der Teilspannung abweichenden Zustandsgrösse dient.

11. Modul nach Anspruch 10, **dadurch gekennzeichnet, dass** zur Detektion einer ans Modul anlegbaren Gesamtspannung der Spannungssensor eine Gruppe von piezoelektrischen Körpern (9) aufweist mit einer allen piezoelektrischen Körpern gemeinsamen zweiten Sensorfaser (10).

12. Modul nach einem der Ansprüche 8 oder 9, **dadurch gekennzeichnet, dass** zur Detektion einer ans Modul anlegbaren Gesamtspannung durch Addition von Teilspannungen der Spannungssensor mindestens zwei piezoelektrische Körper (9) und mindestens zwei Sensorfasem (20) aufweist, von welchen Sensorfasem (20) je eine nur an jeweils einem der piezoelektrischen Körper (9) befestigt ist.

13. Modul nach einem der Ansprüche 10 bis 12, **dadurch gekennzeichnet, dass** der piezoelektrische Körper (9) derart angeordnet ist, dass Säulenabschnitt und Körper (9) bei mit elektrischer Spannung belastetem Modul weitgehend dem gleichen elektrischen Feld ausgesetzt sind.

14. Modul nach Anspruch 13, **dadurch gekennzeichnet, dass** zwei Kontaktflächen des piezoelektrischen Körpers (9) und zwei den Säulenabschnitt begrenzende Kontaktflächen elektrisch leitend miteinander verbunden sind.
